# EUROPEAN PATENT SPECIFICATION

(11) **EP 4 162 774 B1**
(45) Date of publication and mention of the grant of the patent: **22.07.2026**
(21) Application number: 21733517.3
(22) Date of filing: 03.06.2021
(51) Int. Cl.: H05B 47/175, H04L 12/00, H01R 13/514, H02G 3/16, H01R 13/66, H04L 12/403, H01R 9/24, H02G 3/08, H02G 3/12

(54) **MODULAR ELECTRICAL ACCESSORY**
MODULARES ELEKTRISCHES ZUBEHÖR
ACCESSOIRE ÉLECTRIQUE MODULAIRE

(30) Priority: 03.06.2020 GB 202008381
(43) Date of publication of application: 12.04.2023
(73) Proprietor: Source To Site Accessories Limited, St Albans, Hertfordshire AL2 2FL (GB)
(72) Inventor: GODFREY, Michael James, St Albans, Hertfordshire AL2 2FL (GB); SIAU, Loong Yen Johann, St Albans, Hertfordshire AL2 2FL (GB); LALANI, Al-azhar Zaher, St. Albans, Hertfordshire AL2 2FL (GB); HUNTER, Tony Ross, St Albans, Hertfordshire AL2 2FL (GB); DANGOOR, Michael, St Albans, Hertfordshire AL2 2FL (GB)
(74) Representative: Froud, Christopher Andrew
(86) International application number: PCT/GB2021/051383
(87) International publication number: WO 2021/245420

(56) References cited:
- WO-A1-2015/187491
- US-A1- 2017 062 968
- US-A1- 2017 116 483
- US-A1- 2019 296 506

## Description

### Field of the Invention

The present invention relates to a modular electrical accessory for a building including a user-replaceable electrical accessory module. The present invention also relates to a system comprising a user-replaceable electrical accessory module in communication with a further electrical accessory module.

### Background of the Invention

During the construction of a building, a number of electrical accessories are usually installed, such as light switches and electrical sockets. The choice over the type of electrical accessories, and the location at which these electrical accessories are initially installed in the building, is usually decided by the property developer, who typically chooses conventional toggle switches for controlling lights and conventional sockets for mains power outlets based on market knowledge and cost. Alternatively, during their time in a particular property, a previous homeowner may have altered the arrangement of electrical accessories in the property.

When a new homeowner or tenant moves into a property, they may find that the existing arrangement and types of electrical accessories in the property does not suit their needs or preferences. For example, they may wish to replace a toggle switch that operates the lighting in their living room with a dimmer switch. However, the replacement of a toggle switch with a dimmer switch risks exposing the homeowner or tenant to mains voltages, meaning that an electrician should be called to perform the replacement safely, incurring costs to the homeowner and potentially a long wait should the electrician be busy. For tenants of rented properties, the tenant may be restricted from reconfiguring any electrical accessories in the property by conditions in their contract with their landlord, meaning that the tenant has no choice but to live with the existing configuration of electrical accessories, which may not be suited to their particular needs or preferences.

It would therefore be desirable to find an alternate to the conventional installation of electrical accessories in a building described above, that provides a homeowner or tenant with a means of flexibly and safely changing the existing configuration of electrical accessories in a property, that does not require a qualified electrician, or risk causing damage to the property.

Furthermore, during the conventional construction of a building, electrical accessories are installed by an electrician in two separate "fixes".

During the "first fix", metal back boxes are installed in the walls of a building for later mounting electrical accessories, such as light switches and electrical sockets. Electrical cables are run between these back boxes and a mains electricity supply and other devices being controlled by the electrical accessories as appropriate. For example, cables are run between back boxes that will later house light switches and the location for light bulbs that will be controlled by the light switch.

At the end of the "first fix", the electrician usually leaves the ends of the electrical cables coiled within the back box for later connection to the electrical accessory during the second fix and leaves the site until required for the second fix. The electrical accessory is not installed during the first fix because, in-between the first and second fix, workers from a number of other trades will continue with messy jobs, such as plastering, that could damage any installed electrical accessories and spoil their decorative finish.

Once the messy building work, particularly plastering, is complete, the electrician must return to the site for a second time to perform the "second fix". During the second fix, the electrician uncoils the electrical cabling left coiled in each of the metal back box at the end of the first fix and directly wires the electrical cabling to terminals on the relevant electrical accessory before screwing the electrical accessory to the back box.

The need for an electrician to make two separate visits to the site to carry out these two separate fixes is inefficient. Electricians are a skilled trade, making them a relatively expensive form of labour. They are also less readily available than other, non-specialised trades, meaning that the availability of an electrician may introduce delays, with a negative impact on the timescale of the building project and associated cost implications.

It would therefore also be desirable to find an alternative to the first and second fix process described above that reduces the need for a qualified electrician to be required for both fixes.

US 2017/0062968 discloses a configurable network of device controllers. US 2017/116483 A1 discloses a method and apparatus for controlling the automation of building functions. US 2019/296506 A1 discloses a modular and configurable utility system for a building. WO 2015/187491 A1 discloses a lighting control device which offers interchangeable light control features.

### Summary of the Invention

According to a first aspect of the invention, there is provided a modular electrical accessory for a building according to claim 1. The modular electrical accessory comprises a housing for attaching to a building structure (such as a wall), and an electrical backplane mounted in the housing. The electrical backplane is configured to be electrically wired to an electrical circuit associated with the building. A user-replaceable electrical accessory module is removably connectable to the modular electrical accessory by a user.

The modular electrical accessory may further comprise an electrical bus removably connectable to the user-replaceable electrical accessory module. The electrical bus may be configured to transfer electrical power between a connected user-replaceable electrical accessory module and the electrical backplane. The electrical bus may deliver electrical power to a device connected to the electrical bus, for example, based on control signals received over a control bus.

The modular electrical accessory may further comprise a control bus removably connectable to the user-replaceable electrical accessory module. The control bus may be configured to communicate control signals between a connected user-replaceable electrical accessory module and the electrical backplane for controlling delivery of electrical power to an electrical device (for example, electrical power from the electrical bus) based on the control signals. The control bus allows control signals to be sent to and from the user-replaceable electrical accessory module to control the delivery of electrical power to electrical devices connected locally to the electrical bus or externally, for example, to remote user-replaceable electrical accessories and user-replaceable electrical accessory modules.

Having a control bus in addition to an electrical bus between the user-replaceable electrical accessory module and the electrical backplane allows for a more flexible electrical accessory which is more readily able to accommodate a wide range of different functions, changing from light switches to electrical/data outlets, and from control of local to remote devices, all without the need to change the electrical accessory module (avoiding any rewiring to the building circuit). The control bus provides flexibility to locate components in the electrical backplane or the user-replaceable electrical accessory module as needed. For example, a communication interface (such as a wired or wireless communications interface) may be located in the electrical backplane and communicate with the user-replaceable electrical accessory modules via the control bus, minimising unnecessary components in the user-replaceable electrical accessory module and thereby reducing the cost and size of removable modules and reducing waste associated with disposing of useful electronics when a user-replaceable electrical accessory module is replaced. This also allows the communication interface to be shared across multiple user-replaceable electrical accessory modules in a modular electrical accessory, avoiding multiple redundant communications devices which saves cost and avoids overcrowding local network resources.

The electrical circuit associated with the building may be a low voltage electrical circuit (such as a mains electrical circuit), an extra-low voltage electrical circuit (such as a 12V or 5V electrical circuit), a lighting circuit (including a conventional manual direct switching lighting circuit and a bus controlled lighting circuit, like DALI), a communications, data or multimedia circuit. The user-replaceable electrical accessory module may receive electrical power from the electrical circuit. For example, receiving low-voltage (such as mains) or extra-low voltage (such as 12V or 5V) electrical power from the electrical circuit to power the user-replaceable electrical accessory module itself or to power electrical devices connected to the user-replaceable electrical accessory module (such as electrical devices connected to an outlet on the user-replaceable electrical accessory module). The user-replaceable electrical accessory module may be connected to an electrical circuit to control another device. For example, the user-replaceable electrical accessory module may be connected to a lighting circuit (including a conventional manual direct switching lighting circuit and a bus controlled lighting circuit, like DALI) to control lighting. The user-replaceable electrical accessory module may be connected to a communications circuit (such as a network connection), to communicate instructions to control an electrical device. For example, the user-replaceable electrical accessory module may send control signals to control an electrical device connected to a further electrical accessory module remotely.

The modular electrical accessory provides a user with a flexible system for controlling and/or powering electrical devices in their home according to their needs and preferences that overcomes the aforementioned problems associated with previously installed electrical accessories.

The user-replaceable electrical accessory module is interchangeable by the user. The user may change between modules which perform different functions. For example, between a module to control the operation of an electrical device and a module having an outlet connectable to an electrical device to provide electrical or data services to the electrical device. The user may also change between modules which perform the same function but have a different interface, for example, swapping a toggle switch for a dimmer, or switching one kind of electrical outlet for another.

In the event that a user moves into a property and finds that the existing arrangement of modular electrical accessories does not suit their particular needs and/or preferences, the user is able to reconfigure the arrangement of any modular electrical accessory in the property by replacing the user-replaceable electrical accessory module and exchanging it for a different user-replaceable electrical accessory module. For example, an existing user-replaceable electrical accessory module may be configured to be a conventional toggle switch to operate a light bulb. The modular electrical accessory of the present invention allows a user to easily remove the existing user-replaceable electrical accessory module and replace it with a different user-replaceable electrical accessory module themselves, without the need to call a qualified electrician. For example, the user might choose to replace an existing toggle switch module with a module that is configured to act as a dimmer switch to allow selective brightness control of a light bulb.

Alternatively, should an existing user-replaceable electrical accessory fail, the user may simply perform a like-for-like replacement themselves. Since the electrical circuit is connected directly to the electrical backplane, and not to the user-replaceable electrical accessory module, there is no requirement for a qualified electrician to perform the replacement, thereby saving the user time and money. Furthermore, since only the user-replaceable electrical accessory module must be replaced, rather than the entire modular electrical accessory, this reduces waste by reusing the electrical backplane, housing and any faceplate and, in the case of multi-gang electrical accessories, such as multi-gang switches, only the individual faulty electrical accessory module need be replaced.

Another benefit is that user-replaceable electrical accessory modules may be easily upgraded over time, as new technology evolves, without the need to replace the entire electrical accessory and without the need for a qualified electrician to perform the upgrade. For example, while the current standard is to use USB sockets for extra-low voltage electrical outlets for charging and powering portable devices, in the future a different standard may replace USB sockets. The present invention allows a user-replaceable electrical accessory module having a USB socket providing extra-low voltage power to be replaced with whatever extra-low voltage power outlet becomes the new standard, allowing future innovations and developments to be accommodated more easily.

Also, the user-replaceable electrical accessory module may easily be swapped for one tailored to the needs of particular users, or tailored to the changing needs of a user over time. For example, if a person develops a disability or becomes more elderly and finds existing light switches challenging, for example, as a result of reduced vision or mobility, the user-replaceable electrical accessory can be changed by the user or their carer for one that better suits their changing needs, as often as is necessary, without the need for any rewiring. For example, a user-replaceable electrical accessory module could be installed with a touch module with tactile feedback, a switch with braille symbols, a switch with large buttons which are easy to press, a switch controlled by speech, or switch controlled by a user's eye gaze or a motion sensor (such as a PIR sensor).

Additionally, user-replaceable electrical accessory modules may be manufactured by third parties under licence, opening up the market to competition, upgradability and innovation which will provide a greater number and quality of user-replaceable electrical accessory modules to meet a wide range of different needs and applications.

The claimed invention also circumvents the need for an electrician to perform separate so-called "first and second fixes" as discussed above. For example, in the case of the modular electrical accessory being planned to be a light switch, the electrician can install the housing and wire the electrical backplane to an electrical circuit running to a light bulb. The housing and electrical backplane can be left in place, already wired to the light bulb, once the first fix is complete. Once the first fix is complete, anybody, even those without any electrical qualifications, can connect a user-replaceable electrical accessory module to the electrical backplane.

A securing means may be configured to secure the user-replaceable electrical accessory module to the housing. The securing means is configured to secure the user-replaceable electrical accessory module to the housing in order to prevent unintentional removal, for example, to prevent removal except when the user wishes to swap the user-replaceable electrical accessory module. The securing means may be any fastening means which secures the user-replaceable electrical accessory module to the housing to prevent or restrict removal of the user-replaceable electrical accessory module. For example, a faceplate mountable over the user-replaceable electrical accessory module, a fastener which fixes the user-replaceable electrical accessory module to the housing, a push fit, a magnetic coupling, or a clip. The securing means may comprise a locking mechanism to prevent unauthorised removal.

The electrical accessory module may have an interface configured to receive a desired state of operation of an electrical device, such as an electrical device connected to the electrical bus of the user-replaceable electrical accessory module.

The interface may be located on or connected to the user-replaceable electrical accessory module. The interface may receive a desired state of operation of the electrical device from a user (for example, by the user operating a switch or pressing a button on or connected to the user-replaceable electrical accessory module). Additionally or alternatively, the interface may receive input indicating a desired state of operation of the electrical device from a remote device, such as another modular electrical accessory, over a wired or wireless connection.

The interface may comprise a user interface on or connected to the user-replaceable electrical accessory module configured to receive input from a user indicating the desired state of operation of the electrical device. The user interface may comprise one or more switches (toggle switches, push button switches, dimmer switches), a touch panel, a speech recognition processor, a motion sensor, and a variable controller. The user interface may comprise an on/off button. The user interface may comprise one or more inputs, buttons or sliders configured to receive a user input associated with an increase/decrease in, for example, brightness, volume or temperature. The variable controller may be a dimmer switch to control a light bulb, a volume control, or a temperature control.

By each user-replaceable electrical accessory module having a choice of user interface (such as the user interface examples listed above), the user may select a user-replaceable electrical accessory module having an appropriate user interface for their needs with the flexibility to easily change the user-replaceable electrical accessory module themselves for another user-replaceable electrical accessory module having a different user interface should their needs change. This provides a user with a flexible system that allows the user to easily swap the user-replaceable electrical accessory module for one having a different type of user interface to suit their individual preferences and needs in a "plug and play" style. For example, a user may decide that they would prefer a light bulb that is currently operated by a toggle switch (and therefore has a fixed brightness) to instead be operated by a dimmer switch (to allow them to control the brightness of the light bulb). Using the claimed invention, the user could simply replace the user-replaceable electrical accessory module having a toggle switch with a user-replaceable electrical accessory module instead having a variable controller, such as a dimmer switch, to allow them to control the brightness of the light bulb.

The interface may comprise a wired or wireless communications interface configured to communicate the desired state of operation between the communications interface and an external device.

Communicating the desired state of operation comprises sending the desired state of operation to the external device and receiving the desired state of operation from the external device.

The external device may be one or more of: an external electronic device; a bridge; and a further modular electrical accessory.

The external electronic device may be any electronic device connected via a communication link (wired or wirelessly) to the modular electrical accessory. The external electronic device may be a portable electronic device, such as mobile telephone, smartphone, watch and laptop. The external electronic device may send control signals to control the electrical device connected to the user-replaceable electrical accessory module. The modular electrical accessory may send control signals to the external electronic device to control the external electronic device.

The external device may be a further modular electrical accessory, configured to receive one or more control signals from the modular electrical accessory and control an electronic device in communication with the further modular electrical accessory. In one example, the modular electrical accessory may be located on the ground floor of a building and the further modular electrical accessory may be located on the first floor of a building. The modular electrical accessory unit on the ground floor may receive a user input indicative of a user's intention to turn on a light bulb on the first floor of the building. The further modular electrical accessory may be coupled to a light bulb on the first floor, and, upon receiving the one or more control signals from the modular electrical accessory on the ground floor, activate the light bulb. In this way, it is easy to implement and reconfigure remote control of electrical device around a building, particularly if the modular electrical accessory and the further modular electrical accessory communicate wirelessly.

In another example, each of the electrical devices (such as lights or electrical outlets) in a building may be hardwired during building construction to its own electrical accessory module housed in a modular electrical accessory in the form of a central control panel, typically housed in a service area of the building. The property developer may install modular electrical accessories around the building, but leave the user-replaceable electrical accessory modules either blank or with a limited number of generic switches to perform basic functions. A homeowner or tenant is then free to augment or modify the arrangement of user-replaceable modular electrical accessories to control any of the electrical devices in the building from whatever locations suits them best. This makes it very easy to change the location of light switches, for example, to suit changes in occupant or room layout without requiring rewiring.

The modular electrical accessory may communicate with other modular electrical accessories or external devices via a bridge. Each of the modular electrical accessories and the external devices may communicate with the bridge over a private network, with the bridge being optionally connected to a local or wide area network (such as the internet) to allow remote control from outside the building, if desired. Rather than connecting each of the modular electrical accessories and other connected external devices over a local network, such as a local WiFi network, the bridge separates the connected device onto a private network to prevent unwanted tampering, reducing loading on a local WiFi network and allowing connected devices to communicate using a custom communications protocol which might have advantages of reducing interference or improving range as compared with a standard WiFi protocol.

The interface may be configured to control delivery of electrical power to an electrical device connected to the electrical bus. The interface may be configured to output control signals on the control bus. The control signals may indicate a desired state of operation of the electrical device connected to the electrical bus. The control signals on the control bus may control delivery of electrical power to the electrical device connected to the electrical bus.

The modular electrical accessory may further comprise a control component configured to receive control signals from the control bus and control delivery of electrical power by the electrical bus to a device connected to the electrical bus based on the control signals.

The control component may be an electronic switch configured to selectively provide electrical power from the electrical bus to the device connected to the electrical bus based on the control signals received from the control bus. The electronic switch may be a relay or a transistor (such as a MOSFET).

The control component may be in the user-replaceable electrical accessory, allowing the control component to be customised for the electrical device connected to the user-replaceable electrical accessory module and the type of user-replaceable electrical accessory module. For example, allowing a switching component or a dimming component to be chosen as required. Alternatively, the control component may be in the electrical backplane, which may reduce the size and cost of the user-replaceable electrical accessory module. Having the control bus in addition to the electrical bus provides the flexibility to locate components, such as the control component, in either the user-replaceable electrical accessory or electrical backplane.

The modular electrical accessory may further comprise a plurality of user-replaceable electrical accessory modules configured to receive electrical power from the electrical bus and communicate control signals on the control bus. The control signals may further comprise a unique identifier associated with a selected user-replaceable electrical accessory module. A control component may be configured to deliver power to the selected user-replaceable electrical accessory module in response to the control signals comprising the unique identifier associated with the selected user-replaceable electrical accessory module.

The unique identifier identifies a particular user-replaceable electrical accessory module. For example, a user-replaceable electrical accessory module for controlling a particular light bulb may have a different unique identifier to a user-replaceable electrical accessory module for controlling another electrical device, such as a window blind. By including the unique identifier in the control signal, the control signal can be directed to control the desired electrical device.

Connecting the user-replaceable electrical accessory module to the electrical bus may couple the user-replaceable electrical accessory module to the electrical circuit via the electrical backplane. An electrical device may be directly connected via the electrical circuit to the electrical bus to allow the user-replaceable electrical accessory module to control the delivery of electrical power to the electrical device based on control signals on the control bus. For example, the electrical circuit may be a conventional manual direct switching lighting circuit which connects the light bulb to the electrical bus to allow the user-replaceable electrical accessory module to control delivery of electrical power to the lighting circuit in order to control the operation of light bulb.

The user-replaceable electrical accessory module may comprise an outlet for connection to a device. The outlet may provide electrical and/or data services to the electrical device. Data may comprise media data and/or network data.

The user-replaceable electrical accessory module may receive electrical power from the electrical circuit via the electrical backplane. The user-replaceable electrical accessory module may comprises an electrical outlet connectable to an electrical device, wherein the electrical outlet is configured to provide electrical power to the electrical device from the electrical circuit via the electrical backplane.

The outlet may be connected to the electrical bus.

The outlet may comprise a low-voltage (such as mains) electrical outlet and/or an extra-low voltage (such as 12V or 5V) outlet.

Owing to the modular design, a user may easily and safely replace an electrical outlet having a mains electrical outlet for one having an extra-low voltage outlet, or vice versa, without the need for an electrician.

The extra-low voltage outlet may comprise a USB socket that is configured to provide electrical power to operate and/or charge one or more portable electronic devices connected to the USB socket.

The user-replaceable electrical accessory module and the electrical backplane may be electrically connected by one or more interconnects. The one or more interconnects may comprise a physical connector to make an electrical connection between the user-replaceable electrical accessory module and the electrical backplane. The interconnects may comprise one or more pins in the user-replaceable electrical accessory module and one or more corresponding terminals configured to receive the one or more pins in the electrical backplane. Inserting the pins of the user-replaceable electrical accessory into corresponding holes in the electrical backplane provides a simple and secure connection means and ensures the correct alignment of user-replaceable electrical accessory for the transfer of electrical power. Optionally, one or more of the interconnects may comprise a wireless connection, such as radio-frequency, optical or near-field communications. A physical connector to make an electrical connection may be required for connecting the electrical bus between the user-replaceable electrical accessory module and the electrical backplane while a wireless connection may be suitable for connecting the communications bus.

The one or more terminals may have electrical contacts recessed within the one or more terminals so as to prevent a user from touching the contacts. The electrical contacts may be sufficiently recessed such that if a user were to place their finger into the terminals, they would be prevented from contacting any mains supply voltage, thereby improving user safety, and allowing the user to exchange/replace user-replaceable electrical accessories as they please, without needing the assistance of an electrician.

The housing may be an electrical backbox for mounting to a building structure.

The backbox may be mounted into the wall or into the flooring of a building to suit the needs of the user.

A securing means may be a faceplate configured to secure the user-replaceable electrical accessory module to the housing. The faceplate may beuser-attachable to the housing in order to secure the user-replaceable electrical accessory module to the electrical backplane until such a time that the user decides to remove or replace the user-replaceable electrical accessory module. The faceplate may also aid in ensuring electrical connection is maintained between the user-replaceable electrical accessory module and the electrical backplane. The faceplate may be safely removed by the user and replaced with an alternative faceplate.

According to a second aspect of the invention, there is provided a system comprising a (user-replaceable) electrical accessory module in communication with a further electrical accessory module according to claim 14. The electrical accessory module comprises a user interface configured to receive a desired state of operation of an electrical device connected to the further electrical accessory module. The electrical accessory module comprises a communication interface configured to send a control signal indicating the desired state of operation to the further electrical accessory module. The further electrical accessory module comprises a communication interface configured to receive the control signal from the electrical accessory module and a control component configure to control the supply of electrical power to the electrical device connected to the further electrical accessory module based on the control signal.

The claimed system allows for the control of electrical devices (for example, in a building) that are located in different locations (for example, different parts of the building). For example, it may be desirable to provide a light switch at the bottom of stairs which turns on/off a light located upstairs without having to run dedicated cables. Or, it might be desirable to provide a switch near an entrance to a room which turns on/off a table lamp located on the opposite side of the room, without the expense of running dedicated cables between the light switch and the lamp. The system allows electrical accessory modules, which might be in separate modular electrical accessory housings, to communicate with one another, so that a switch in one location can control a switch in another location, such as the switch at the bottom of stairs sending a control signal to the switch connected to the light upstairs to turn on/off the light. Therefore, when a user inputs a command indicating a desired state of operation of the electrical device (for example, flicking a switch or turning a dial) using the electrical accessory module at the user's location, a control signal associated with the desired state of operation is communicated to a further electrical accessory module connected to the remote electrical device causing the further electrical accessory module to operate the electrical device at the different location according to the control signal (for example, to turn a light on or off, or to control the temperature of a radiator).

Any or all of the electrical accessory modules may be user-replaceable, such that they can be changed by the homeowner or tenant without requiring an electrician. It becomes straightforward to reconfigure the arrangement of switches in a building without requiring an electrician to rewire, eliminating the expense and damage caused by running cables. Instead, an appropriate electrical accessory module can be installed in a modular electrical accessory at a location of choice and programmed to send a control signal to control the appropriate further (remote) electrical accessory.

A user-replaceable electrical accessory module may be removably connectable to a communication interface in a modular electrical accessory by a control bus for communicating control signals between the user-replaceable electrical accessory module and the communication interface. The user interface may communicate the desired state of operation as control signals on the control bus and the communications interface may receive the control signals from the control bus. The further user-replaceable electrical accessory module may be located in a further modular electrical accessory with an electrical bus and a further control bus removably connectable to the further user-replaceable electrical accessory module. The electrical bus is configured to transfer electrical power to the further user-replaceable electrical accessory module and the further control bus is configured to communicate control signals to the further user-replaceable electrical accessory module. A further communication interface in the further modular electrical accessory may be configured to receive the control signals from the modular electrical accessory and communicate the control signals over the further control bus to the further user-replaceable electrical accessory module. The control component in the further user-replaceable electrical accessory module may be configured to control the supply of electrical power to the electrical device connected to the electrical bus of the further user-replaceable electrical accessory module based on the control signals received on the further control bus.

The modular electrical accessory may be installed at a first location in a building and the further modular electrical accessory may be installed at a second location in the building remote from the first location. For example, to allow a device to be controlled from two different locations, such as providing a light switch at the top and bottom of a flight of stairs.

A modular electrical accessory may be a control panel which may be installed in a service area of a building. The control panel may house a plurality of electrical accessory modules, each connected to one of the electrical devices in the building to control it (by controlling its supply of electrical power either by direct switching of power supplying the electrical device or by sending appropriate control signals to operate the electrical device). User-replaceable electrical accessories modules to control any of the electrical devices in the building can then be installed in whatever locations suit a user best. The user-replaceable electrical accessory modules are programmed to communicate with the appropriate electrical accessory modules in the control panel which controls the desired electrical device without any physical alternations to the building's wiring being required. This makes it very easy to change the location of light switches, for example, to suit changes in occupant or room layout by simply moving user-replaceable electrical accessory modules around and/or reprogramming them, without requiring any physical rewiring of the building or the services of a qualified electrician.

An electrical accessory module and a further electrical accessory module may share a common housing. One electrical accessory module may be a switch which controls one or more other electrical accessory modules which are each controlling separate electrical devices. This allows a zone to be easily created and reconfigured. For example, the backplane may be wired to a set of light bulbs in a room and each light bulb may be associated with an individual electrical accessory module which controls each of the light bulbs. Each of these individual electrical accessory modules could present a switch or dimmer to the user for individual control of its light bulb. Alternatively, the user could replace all but one of the individual electrical accessory modules with ones that do not present a switch or dimmer to the user and reprogram the electrical accessory modules presenting the switch to control the whole set of light bulbs. The electrical accessory module with the switch would send control signals to the other electrical accessory modules to turn them on/off at the same time. In this way, reconfiguring a zone requires no rewiring, and simply involves reprogramming which electrical accessory modules react to the control signal. Likewise, it becomes straightforward to swap control of the entire zone from a simple on/off switch to a dimmer switch by simply replacing the single electrical accessory module with the switch with a dimmer instead, without the need for any complicated rewiring and without requiring an electrician.

The system may further comprise a plurality of further electrical accessory modules each having a unique identifier. The control signal may comprise a selected unique identifier associated with a selected one of the plurality of further electrical accessory modules. The further electrical accessory module having a unique identifier corresponding with the selected unique identifier is configured to control its connected electrical device based on the control signal, for example, to provide electrical power to the electrical device connected to its electrical bus based on the control signal received on its control bus.

The system may further comprise a bridge in communication with the electrical accessory module and the plurality of further electrical accessory modules. The bridge may be configured to receive the control signal from the electrical accessory module and transmit the control signals to the plurality of further electrical accessory modules or to the further electrical accessory module associated with the unique identifier.

The bridge may be any device capable of receiving and transmitting control signals from the electrical accessory module to the plurality of further electrical accessory modules. For example, the bridge may be a gateway device, a wireless hub, or an app. The bridge may communicate remotely with any electrical accessory module connected to it. In one example, the bridge may receive a control signal from an electrical accessory module and broadcast the control signal to all other further electrical accessory modules in communication with the bridge. In another example, the bridge may receive a control signal from an electrical accessory module to operate a particular electrical device and, based on a unique identifier associated with the control signal, identify an electrical accessory module connected to the particular electrical device and send the control signal to that electrical accessory module to operate the particular electrical device.

According to a third aspect of the invention, there is provided a user-replaceable electrical accessory module according to claim 15. The user-replaceable electrical accessory module is removably connectable by a user to an electrical backplane of a modular electrical accessory according to the first aspect. The user connecting the user-replaceable electrical accessory module to the electrical backplane may couple the user-replaceable electrical accessory module to an electrical circuit of a building via the electrical backplane. The user-replaceable electrical accessory module may be removably connectable by the user to an electrical bus and/or a control bus of the modular electrical accessory.

The user-replaceable electrical accessory module may further comprise an interface configured to receive a desired state of operation of an electrical device.

The interface may comprise a user interface configured to receive input from a user indicating the desired state of operation of the electrical device. For example, the user interface may comprise one or more of: a toggle switch; one or more push button switches; a dimmer switch; a touch panel; a speech recognition processor; a motion sensor; and a variable controller.

The interface may comprise a wired or wireless communications interface configured to communicate the desired state of operation between the communications interface and an external device, such as, an external electronic device, a bridge, and a further modular electrical accessory.

The user-replaceable electrical accessory module may further comprise an outlet connectable to an electrical device to provide electrical or data services to the electrical device.

### Brief Description of the Drawings

The invention shall now be described, by way of example only, with reference to the accompanying drawings, in which:
Figure 1 illustrates a prior art electrical accessory;
Figure 2 illustrates a prior art two-way switch;
Figure 3 illustrates an exploded three-dimensional view of a modular electrical accessory according to an embodiment of the invention;
Figure 4 is an exploded cross-sectional side view of the modular electrical accessory of Figure 3;
Figure 5 illustrates electrical connections between a user-replaceable electrical accessory module and an electrical backplane;
Figure 6 is a block diagram showing electrical outlets of the user-replaceable electrical accessory module;
Figure 7 illustrates the modular electrical accessory controlling an external device;
Figure 8 illustrates an external device controlling the modular electrical accessory; and
Figure 9 illustrates a first electrical accessory module controlling a device connected to a second electrical accessory module.

### Detailed Description

Conventional electrical accessories (such as light switches and mains electrical sockets) have a faceplate with a front side having sockets and/or switches accessible to a user during normal use and a rear side with terminals for making permanent electrical connections (for example, to a mains electricity supply) usually by screwing or crimping electrical cables to the terminals. Making any changes to these conventional electrical accessories (such as changing a toggle switch for a dimmer switch, or changing a mains electrical socket for one having extra-low voltage outlets, such as USB sockets, for providing extra-low voltage power to portable electronic devices) requires these electrical connections to be disconnected and reconnected which, as mains voltages are involved, usually requires the services of a qualified electrician.

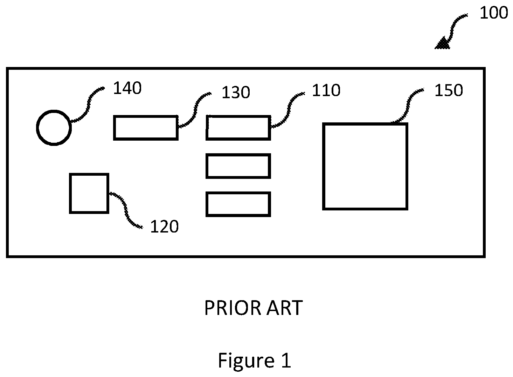

Specialist electrical accessories are available which provide multimedia connections in addition to mains power. These are typically mounted in a wall adjacent to where a television might be located, to provide electrical power and multimedia connections to the television. Figure 1 shows an example of such an electrical accessory 100 which offers audio-visual ports 110 (e.g. HDMI, VGA, etc), a network port 120 configured to provide an ethernet internet connection, one or more USB data ports 130, an audio port 140 (such as a headphone jack), and a mains electrical socket 150. Whilst the electrical accessory 100 provides a convenient "all-in-one" product to connect and power a number of different peripherals from a single unit, electrical connections must again be made to terminals associated with each port on the rear side of the faceplate. Even in cases where the individual ports are modular and can be changed to suit an individual user's requirements, it is still necessary to modify hardwired connections to terminals associated with each individual port.

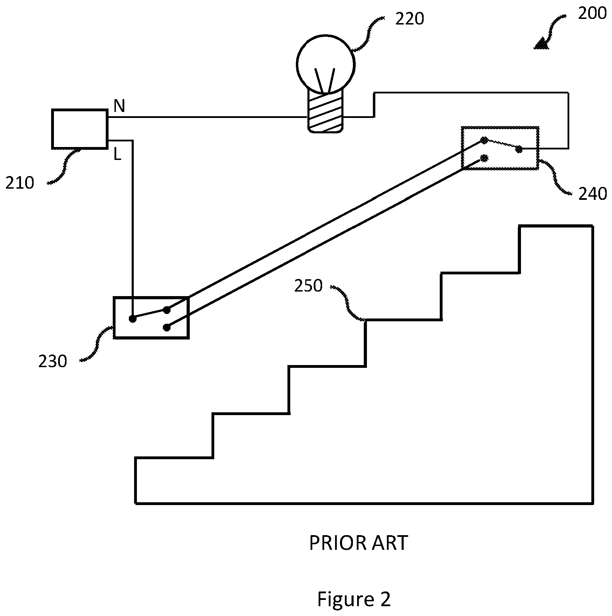

It is often desirable in a building to provide a way to control a light or other electrical device from several different locations, such as from either end of a corridor or from the top and bottom of stairs. Figure 2 shows an example of a conventional two-way switching arrangement 200 which is used to control a light bulb 220 from two different locations in a building. In this example, the light bulb 220 can be controlled by a first light switch 230 at the bottom of a flight of stairs 250 and a second light switch 240 at the top of the flight of stairs 250. This allows a user to turn the light bulb 220 on to illuminate the stairs 250 before negotiating the stairs 250 in either direction, and turn the light bulb 220 off afterwards. In this conventional arrangement, a substantial amount of cabling must be run between the light bulb 220 and the switches 230 and 240. This makes it difficult to add a new two-way light switch where one was not present previously and makes it more difficult to make changes such as moving the location of any of the components since any changes incur the cost of repairing damage to the walls and ceilings when running new cables.

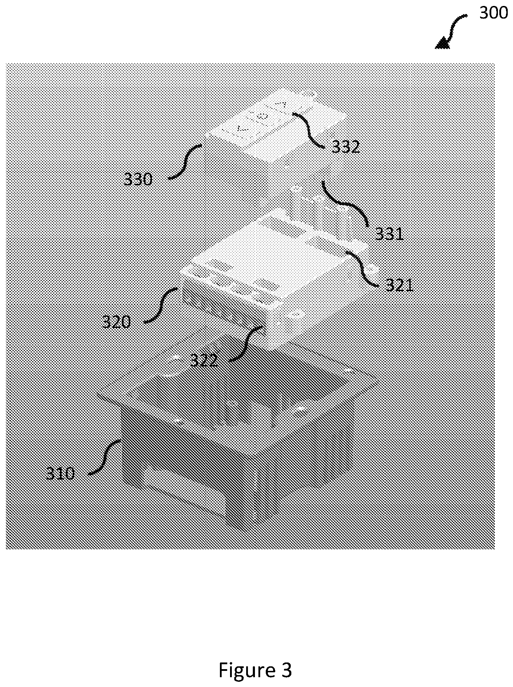

Figure 3 is an exploded three dimensional view of a modular electrical accessory 300 according to the present invention which seeks to overcome the shortcomings with existing electrical accessories. The modular electrical accessory 300 has a housing such as a backbox 310 for recessing into a building structure (such as a wall, floor, or ceiling), although other housings might be surface mounted as desired.

The modular electrical accessory 300 has an electrical backplane 320 mounted within the backbox 320. The electrical backplane 320 has terminals 322 that can be hardwired to an electrical circuit of the building by a qualified electrician. The electrical circuit may be a low voltage electrical circuit (such as a mains electrical circuit), an extra-low voltage electrical circuit (such as a 12V or 5V electrical circuit), a lighting circuit (including a conventional manual direct switching lighting circuit and a bus controlled lighting circuit, like DALI), a communications, data or multimedia circuit. In this example, the modular electrical accessory 300 includes buttons 332 and therefore the terminals 322 of the electrical backplane 320 might be hardwired to an electrical device which is to be controlled by these buttons (such as one or more light bulbs).

The user-replaceable electrical accessory module 330, can easily be inserted into and removed from the backplane 320 by a user, without any electrical knowledge whatsoever and without the need for a qualified electrician. The user-replaceable electrical accessory module 330 and the electrical backplane 320 are coupled by interconnects which transfer electricity and optionally control signals between the user-replaceable electrical accessory 330 module and the electrical backplane 320.

In this example, the interconnectors are provided by pins 331 on the user-replaceable electrical accessory module 330 which couple with corresponding recessed terminals 321 in the electrical backplane 320. The use of pins 331 and recessed terminals 321 may protect the user from exposure to mains voltages. The shape of the module and/or the pins may be keyed to ensure correct alignment. Instead of pins 331 and terminal 321, any other kind of interconnects or connectors could be used for transferring electricity and/or control signals between the user-replaceable electrical accessory module 330 and the electrical backplane 320, For example, control signals need not require a direct electrical connection and could be transferred by a wireless (radio-frequency), optical, or near field communications link instead.

As a result, the user-replaceable electrical accessory module 330 may be swapped by the user, for example, to allow the user to change the user-replaceable electrical accessory module 330 if it becomes faulty or should they wish to change its functionality (such as swapping the buttons shown in Figure 3 for a rotary dial), without the need for a qualified electrician. As soon as the user-replaceable electrical accessory module 330 is connected to the electrical backplane 320, the user-replaceable electrical accessory module 330 is connected into the electrical circuit to the light bulb via the backplane 330, without the need to modify the wiring to the terminals 322.

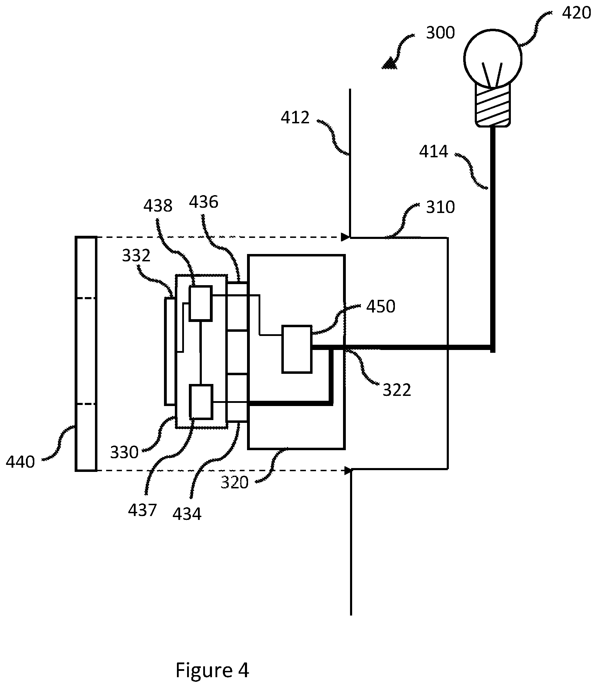

Figure 4 is an exploded cross-sectional side-view of the modular electrical accessory 300 to show the internal components.

The housing 310 is recessed into a cut-out in a wall 412 of a building. Cable 414 is buried in the wall. The cable 414 forms at least part of an electrical circuit which provides electrical power to the modular electrical accessory 300 and connects the modular electrical accessory 300 to a light bulb 420 that is controllable by the buttons 332.

Cables 414 are fed through an opening in the housing 310 and electrically connected to terminals 322 on the electrical backplane 320. The electrical backplane 320 is positioned within the housing 310.

The user replaceable electrical accessory 330 is shown connected to the electrical backplane 320, and a faceplate 440 (not shown in Figure 3 for clarity purposes) is positioned over the user-replaceable electrical accessory module 330. The faceplate 440 comprises a cut-out section to accommodate the buttons 332 of the user-replaceable electrical accessory module 330 (shown by dashed lines in Figure 4). The faceplate 440 is attached to the housing 310 (for example, with screws or clips) to secure the user-replaceable electrical accessory in place (shown by dashed arrows in Figure 4) and prevent unintentional removal.

The user-replaceable electrical accessory module 330 has an electrical bus 434 connected between the user-replaceable electrical accessory module 330 and the electrical backplane 320. The terminals 322 terminating cables 414 are connected to the electrical bus 434, such that the electrical supply to the light bulb 420 is connected to the electrical bus 434 via cables 414. A switching component 437 in the user-replaceable electrical accessory module 330 controls the flow of power on the electrical bus 434 to the light bulb 420 according to user input at buttons 332.

Pressing buttons 332 causes the processor 438 in the user-replaceable electrical accessory module 330 to generate a control signal on a control bus 436. The switching component 437 is connected to the control bus 436 and the control signal causes the switching component to selectively couple electrical power to the light bulb 320 over the electrical bus 434 depending on the control signal.

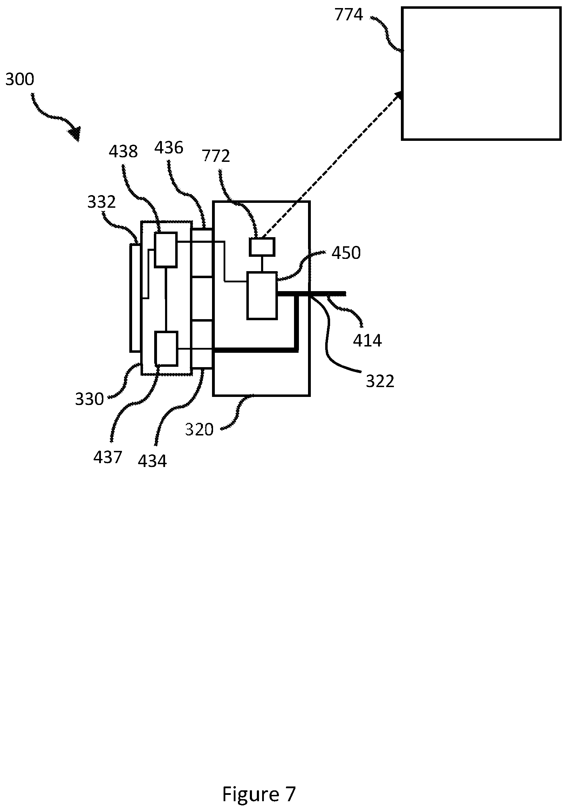

The control bus 436 is also connected between the user-replaceable electrical accessory module 330 and the electrical backplane 320, in order to transfer control signals between the user-replaceable electrical accessory module and a processor 450 in the electrical backplane 320. As will be discussed in more detail in Figures 7, 8 and 9, this allows the control signals to be sent to and from the user-replaceable electrical accessory module 330 to control other electrical devices, to allow the user-replaceable electrical accessory module to be controlled by other electrical devices, or to allow remote control of other user-replaceable electrical accessory modules. In this example, the control bus 436 is shown as a wired connection between the user-replaceable electrical accessory module 330 and the electrical backplane 320, but a wireless connection (such as RF, optical or near-field) could be used instead.

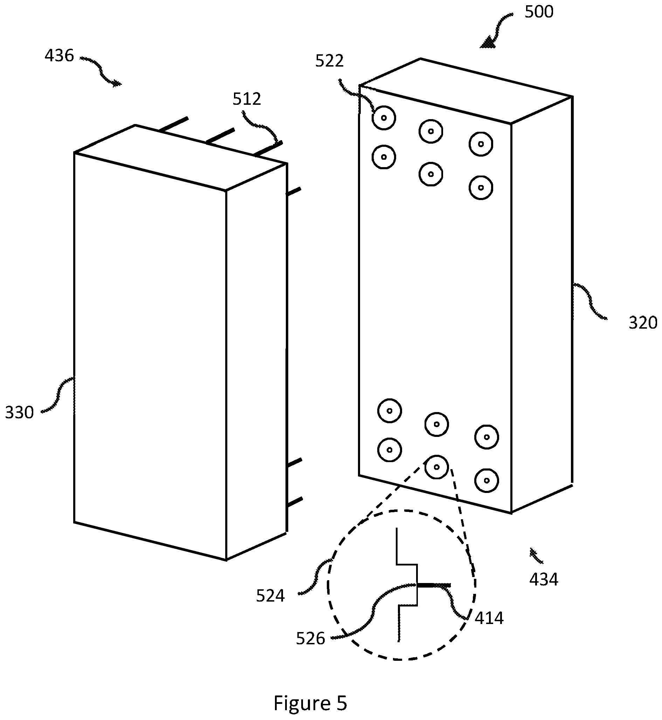

Figure 5 is a diagram illustrating how the user-replaceable electrical accessory module 330 is electrically connected to the electrical backplane 320. The user-replaceable electrical accessory module has two sets of connectors comprising pins 512 on the user-replaceable electrical accessory module and corresponding terminals 522 to receive the pins 512 on the electrical backplane 320. The upper set of pins connects the control bus 436 and the lower set of pins connects the electrical bus 434. However, the upper set of pins for the control bus 436 could be omitted if the user-replaceable electrical accessory module 330 and electrical backplane 320 were connected by a wireless connection.

Also shown in Figure 5 is an enlarged view 524 of one terminal 522, where electrical contact 526 is shown recessed within terminal 522 of electrical backplane 320, in order to protect a user from exposure to the mains supply voltage received from the electrical circuit 414.

The user-replaceable electrical accessory module 330 could be swapped by the user for a different user-replaceable electrical accessory module having different controls (for example, swapping the push buttons 332 shown in Figure 3 for a rotary dial). Alternatively, the user-replaceable electrical accessory module 330 could be swapped for a different user-replaceable electrical module providing different functionality. For example, if a light switch module is no longer required at a particular location, the light switch module may be swapped for an electrical outlet which may draw its electrical power from the electrical circuit which provides electrical power to the modular electrical accessory 300.

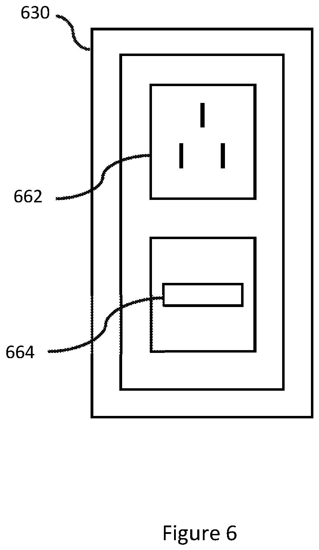

Figure 6 shows an alternative example of a user-replaceable electrical accessory module 630 with a mains electrical outlet 662 for supplying mains electrical power to an electrical device connected to the electrical outlet 662 and an extra-low voltage electrical outlet in the form of USB socket 664 for supplying an extra-low voltage (such as 5V) to a portable electrical device (such as a smartphone).

The mains electrical outlet 662 receives mains electrical power from the electrical bus 434.

The USB socket 664 receives extra-low voltage from the electrical bus 434 (where the transformer is in the electrical backplane 320), or a transformer in the user-replaceable electrical accessory module 330 converts the mains electrical power from the electrical bus 434 into an extra-low voltages supply for the USB socket 664.

Other user-replaceable electrical accessory modules with different arrangements of electrical outlets are available, for example, user-replaceable electrical accessory modules with just a low voltage outlet or outlets (such as a mains outlet or outlets) and others with just an extra-low voltages outlet (or outlet). This allows a user to easily swap a low voltage outlet (such as a mains outlet) for an extra-low voltage outlet by simply swapping the user-replaceable electrical accessory module, without the need for any rewiring, electrical qualifications or indeed any specialist electrical knowledge. This may be advantageous if the standard for extra-low voltage outlets changes in the future (for example, from USB outlets prevalent today to something else), as it would allow the outdated outlets to be replaced for modern outlets without the need for rewiring and with a minimum of waste.

The outlets may also be easily replaced for other kinds of outlets as well, such as media or network outlets, where the media or network data may be provided over the control bus 436 from a wired or wireless communications link to the electrical backplane 320.

Figure 7 illustrates how the modular electrical accessory 300 can control an external device 774.

As discussed in relation to Figure 4, pressing buttons 332 on the user-replaceable electrical accessory module 330 causes the processor 438 in the user-replaceable electrical accessory module 330 to generate a control signal on the control bus 436. However, rather than these control signals causing switching component 437 to couple electrical power over the electrical bus 434 to a device directly wired to the electrical bus 434 (such as the light bulb 320 in Figure 4), the control signals on the control bus may additionally or alternatively be sent to an external device 774 to control the external device 774 remotely.

For example, first and second light switches may be located at opposite ends of a hallway for controlling a single light bulb, so that the light bulb can be turned on/off from either end of the hallway. However, only the second light switch may be electrically wired to the light bulb with the first light switch sending wireless control signals to control the light bulb via the second light switch when a user presses buttons on the first light switch. For example, when the user presses an on button on the first light switch, the first light switch sends a control signal to the second light switch instructing the second light switch to couple electrical power to the light bulb to turn it on.

The control bus 436 is connected between the user-replaceable electrical accessory module 330 and the electrical backplane 320, in order to transfer control signals between the user-replaceable electrical accessory module and the processor 450 in the electrical backplane 320.

The processor 450 receives the control signals from the control bus 436 and the processor 450 transmits these control signals to external device 774 using wireless transceiver 772. Since there may be more than one external device, the control signals include a unique identifier which allows the external devices to determine whether the control signals are meant for them. The control signal causes the external device 774 to be controlled according to the button presses, for example, turning the external device 774 on/off.

The external device need not be local to the user-replaceable electrical accessory module 330 that is controlling it. That is, the external device could be in a remote location such as a different building and the control signals may be transmitted over a wired or wireless network (including over the internet) to the remote location. For example, the external device might be a light in an outbuilding and the user-replaceable electrical accessory module may be a light switch located in the main building for remotely turning on/off the light in the outbuilding.

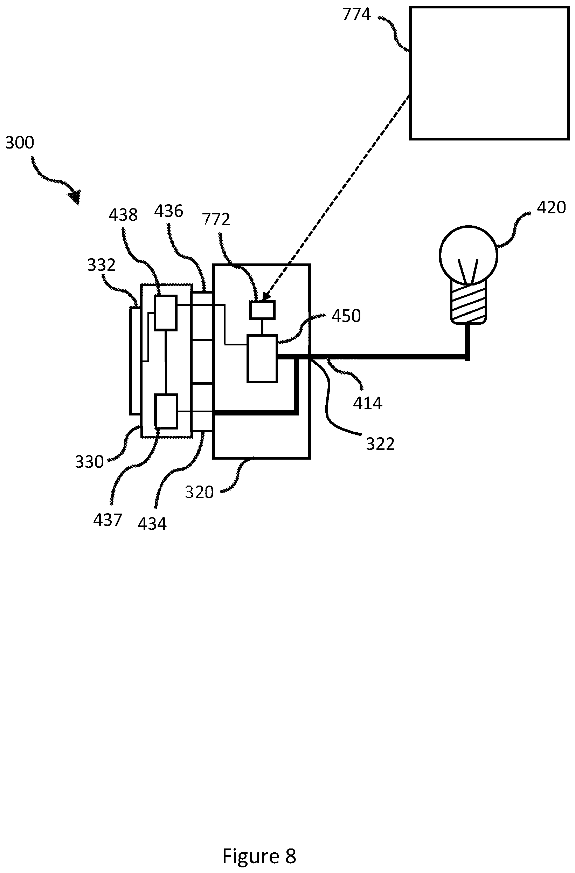

As shown in Figure 8, the external device may also control the user-replaceable electrical accessory module 330, to allow for remote control of an electrical device connected to the user-replaceable electrical accessory module.

The external device 774 send a control signal including a unique identifier that identifies the user-replaceable electrical accessory module 330 the control signal is intended for. The wireless transceiver 772 receives the control signal and the processor 450 passes the control signal to the control bus 436 where the processor 438 in the user-replaceable electrical accessory module determines that the unique identifier associated with the control signal indicates that the control signal is intended for the user-replaceable electrical accessory module 330 and the processor 438 instructs the switching component 437 to selectively provide electrical power on the electrical bus 434 to control the light bulb 420 according to the instructions of the external device 774.

The external device 774 need not be local to the user-replaceable electrical accessory module 330 that it is controlling. That is, the external device 774 could be in a remote location such as a different building and the control signals may be transmitted over a wired and/or wireless network (including over the internet) to the user-replaceable electrical accessory module 330. For example, the external device might be a smartphone and the user-replaceable electrical accessory module may be a light switch located in a house, and the smartphone can be used to remotely turn on/off the light from outside the house.

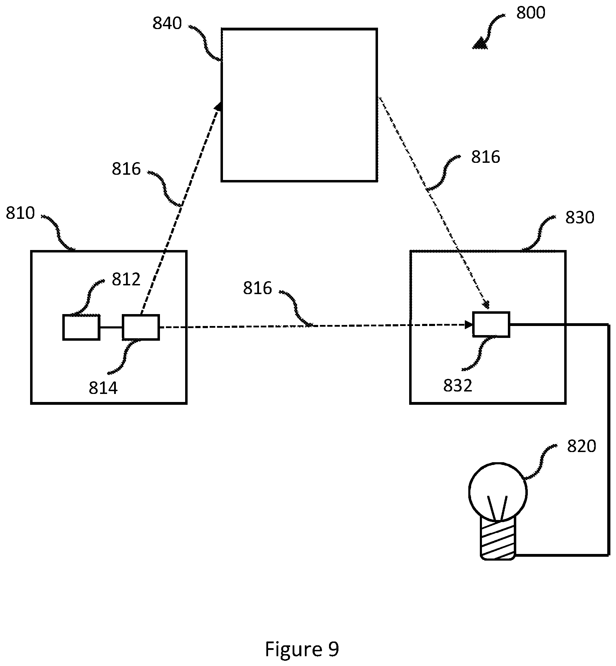

Figure 9 illustrates an example of a system 800 where a first electrical accessory module 810 may control a light bulb 820 (or other electrical device) connected to a second electrical accessory module 830 that may be remote from the first electrical accessory module 810.

A user presses a button 812 on the first electrical accessory module 810 to indicate a desired state (on/off) of the light bulb 820. Pressing the button 812 generates a control signal indicating the desired state of the light bulb 820, for example in the manner discussed in relation to Figures 4, 7 and 8. A communications interface 814 sends the control signal, either directly to the second electrical accessory module 810 (peer-to-peer) or via a bridge 840 which retransmits the signal to the second electrical accessory module 830. Either way, the second electrical accessory module 830 has a second communication interface 832 that receives the control signal 816 from the first electrical accessory module 810, and selectively controls the power to the light bulb 820 according to the desired state as discussed in Figure 4.

The bridge 840 may be connected to a wide area network (such as the internet) via a wired or wireless connection, to allow any of the electrical accessory modules, such as the first and second electrical accessory modules 810, 830, to be controlled and monitored remotely.

This example could be used to implement a two-way switch where a light bulb 820 may be controlled from either ends of a corridor, or from both the bottom and top of a flight of stairs.

This example can also be used to assist in reconfiguring the location of controls for electrical device (such as switches for lights) and electrical outlets in a building without any rewiring. Each of the electrical devices (such as lights and electrical outlets) in a building can be hardwired during building construction or refurbishment to a control panel, typically located in a service area of the building. The control panel is essentially a modular electrical accessory, such as the modular electrical accessory 300, but on a larger scale since it can house enough electrical accessory modules so that one can be wired to each of the electrical devices in the building.

A property developer may install modular electrical accessories around the building and wire them into an electrical circuit to provide them with power, but leave the user-replaceable electrical accessory modules either blank so that the homeowner or tenant can decide how to populate them, or with a limited number of generic switches and outlets to perform basic functions. A homeowner or tenant is then free to augment or modify the arrangement of user-replaceable electrical accessories modules to suit their needs, for example, to control any of the electrical devices in the building from whatever locations suits them best. The user-replaceable electrical accessory modules the homeowner or tenant installs are then programmed to communicate with the electrical accessory modules in the control panel to control the desired electrical device without any physical alternations to the building's wiring being required. This makes it very easy to change the location of light switches, for example, to suit changes in occupant or room layout without requiring rewiring or the services of a qualified electrician.

Although the invention has been described in terms of certain embodiments, the skilled person will appreciate that various modifications could be made which would still fall within the scope of the claimed invention.

The user-replaceable electrical accessory module 330 has been described as including buttons 332 as an example control component to enable a user to control an electrical devices connected to the user-replaceable electrical accessory module 330. The buttons 332 may be in the form of a toggle switch, a push button switch, a rotary dial, a touch screen or a touch panel. In a further example, the control component may be a variable controller. The variable controller may be a dimmer switch to control the brightness of a light bulb connected to the electrical circuit. The variable controller may be a volume control to adjust playback volume of a sound system in communication with the modular electrical accessory. As a further example, the variable controller may be a temperature control to adjust the temperature of a heating device (for example a radiator) in communication with the modular electrical accessory.

Instead of buttons 332, the user-replaceable electrical accessory module 330 may alternatively or additionally include other control components to allow the user to control an electrical device connected to the user-replaceable electrical accessory module 330. For example, the user-replaceable electrical accessory module may include a motion sensor (such as a PIR sensor) configured to detect the movement of a user within a particular zone of the building and control the electrical device based on the movement of the user (for example, turning a light connected to the module on if movement is detected). Alternatively or additionally, a speech recognition processor may control the electric device according to voice commands, for example a voice command to turn on the light bulbs in a particular room or rooms of the building. An eye-gaze sensor may detect and track a user's eye gaze to control the electrical device connected to the user-replaceable electrical accessory module 330.

Swapping the user-replaceable electrical accessory for a new one with a different user interface (such as swapping a conventional toggle switch with a PIR sensor) makes it very straightforward for a user to tailor the way electrical devices in the building are operated, even if these requirements were not envisaged at the time the building was configured. This provides flexibility to change and upgrade the configuration over time as technology develops or needs change.

For example, the user-replaceable electrical accessory module 330 may be a module which has been specifically tailored to the needs of particular users, such as those with disabilities or the elderly, allowing their needs to be met by simply switching the user-replaceable electrical accessory module 330 to one best suited to their needs, as often as is necessary, without the need for any rewiring. For example, the user-replaceable electrical accessory module 330 may be a touch module with tactile feedback, a switch with braille symbols, a switch with large buttons which are easy to press, or a switch controlled by speech, a motion sensor (such as a PIR sensor) or a user's eye gaze.

In the above examples, the electrical device connected to and controlled by the user-replaceable modular electrical accessory has been shown as a light bulb. However, the electrical device could instead be another electrical device, such as, one or more peripheral external electrical devices, a central heating system, a sound system, a doorbell, an extractor fan, or any other suitable electrical device.

The outlet may additionally or alternatively include a multimedia outlet for supplying media data to a device connected to the multimedia outlet. In another example, the electrical outlet may include a network outlet for communicating network data with the electrical device connected to the network outlet. The multimedia outlet and network outlet may communicate data from the wireless transceiver in the electrical backplane over the control bus.

The wireless transceiver 772 has been described as being in the electrical backplane 320. However, a wireless transceiver 772 could be provided in the or each user-replaceable electrical accessory module 330, thereby eliminating the need for the control bus 436.

## Claims

1. A modular electrical accessory (300) for a building, the modular electrical accessory (300) comprising:
a housing (310) configured for attaching to a building structure;
an electrical backplane (320) mounted in the housing (310), the electrical backplane (320) configured to be electrically wired to an electrical circuit associated with the building;
an electrical bus (434) and a control bus (436) removably connectable to a user-replaceable electrical accessory module (330) by a user;
wherein the electrical bus (434) is configured to transfer electrical power between a connected user-replaceable electrical accessory module (330) and the electrical backplane (320); and
the control bus (436) is configured to communicate control signals between a connected user-replaceable electrical accessory module (330) and the electrical backplane (320) is configured for controlling delivery of electrical power to an electrical device based on the control signals.

2. The modular electrical accessory (300) of claim 1, wherein the user-replaceable electrical accessory module (330) is interchangeable by the user between:
a module to control the operation of an electrical device; and
a module having an outlet connectable to an electrical device to provide electrical and/or data services to the electrical device.

3. The modular electrical accessory (300) of either of claims 1 and 2, wherein an electrical device is connected to the electrical bus (434) and the user-replaceable electrical accessory module (330) is configured to control delivery of electrical power to the electrical bus (434) based on control signals from the control bus (436) in order to control the operation of the electrical device, wherein the electrical bus (434) is configured to receive electrical power from the electrical circuit via the electrical backplane (320).

4. The modular electrical accessory (300) of claim 3, wherein the user-replaceable electrical accessory module (330) comprises an electrical outlet connectable to an electrical device, wherein the electrical outlet is configured to provide electrical power to the electrical device from the electrical bus (434), optionally wherein the outlet comprises a low voltage electrical outlet and/or an extra-low voltage electrical outlet.

5. The modular electrical accessory (300) of either of claims 3 or 4, wherein the modular electrical accessory (300) further comprises a transceiver powered by electrical power received from the electrical bus, wherein the transceiver is configured to communicate data with an external device, and the user-replaceable electrical accessory module further comprises an outlet connectable to an electrical device, wherein the outlet is configured to communicate the data with the electrical device.

6. The modular electrical accessory (300) of any preceding claim, where the modular electrical accessory (300) has an interface configured to receive a desired state of operation of an electrical device.

7. The modular electrical accessory (300) of claim 6, wherein the interface comprises a user interface configured to receive input from a user indicating the desired state of operation of the electrical device, for example, one or more of: a toggle switch; one or more push button switches; a dimmer switch; a touch panel; a speech recognition processor; a motion sensor; and a variable controller.

8. The modular electrical accessory (300) of claim 6, further comprising a wired or wireless communications interface configured to communicate the desired state of operation between the communications interface and an external device, wherein the external device is one or more of: an external electronic device; a bridge; and a further modular electrical accessory.

9. The modular electrical accessory (300) of any of claims 6 to 8, wherein the interface is configured to control delivery of electrical power to an electrical device connected to the electrical bus (434), wherein the control bus (436) is configured to communicate control signals from the interface for controlling delivery of electrical power by the electrical bus (434) to the electrical device based on the control signals,
wherein the interface is configured to output control signals on the control bus (436) indicative of the desired state of operation of the electrical device.

10. The modular electrical accessory (300) of any preceding claim, wherein the electrical backplane (320) further comprises a wired or wireless communications interface configured to communicate control signals between the control bus (436) and an external device.

11. The modular electrical accessory (300) of any preceding claim, further comprising a control component configured to:
receive control signals from the control bus (436); and
control delivery of electrical power by the electrical bus (434) to the electrical device based on the control signals.

12. The modular electrical accessory (300) of claim 11, further comprising:
a plurality of user-replaceable electrical accessory modules (330) configured to receive electrical power from the electrical bus (434) and communicate control signals on the control bus (436),
wherein the control signals further comprise a unique identifier associated with a selected user-replaceable electrical accessory module (330), and
a control component configured to deliver power to the selected user-replaceable electrical accessory module in response to the control signals comprising the unique identifier associated with the selected user-replaceable electrical accessory module (330).

13. The modular electrical accessory (300) of any preceding claim, wherein the housing is an electrical backbox for mounting to a building structure, further comprising a faceplate configured to secure the user-replaceable electrical accessory module (330) to the electrical backbox.

14. A system comprising a modular electrical accessory in communication with a further modular electrical accessory, wherein:
the modular electrical accessory comprises:
a user-replaceable electrical accessory module removably connectable to a communication interface in the modular electrical accessory by a control bus for communicating control signals between the user-replaceable electrical accessory module and the communication interface, wherein the user-replaceable electrical accessory module comprises a user interface configured to receive a desired state of operation of an electrical device connected to the further electrical accessory module and communicate the desired state of operation as control signals on the control bus;
wherein the communication interface is configured to receive the control signal from the control bus and send the control signal indicating the desired state of operation to the further modular electrical accessory; and
the further modular electrical accessory comprises:
an electrical bus and a further control bus removably connectable to a further user-replaceable electrical accessory module, wherein the electrical bus is configured to transfer electrical power to the further user-replaceable electrical accessory module and the further control bus is configured to communicate control signals to the further user-replaceable electrical accessory module;
a further communication interface configured to receive the control signals from the modular electrical accessory and communicate the control signals on the further control bus to the further user-replaceable electrical accessory module;
wherein the further user-replaceable electrical accessory module comprises a control component configured to control the supply of electrical power to the electrical device connected to the electrical bus based on the control signal received on the further control bus.

15. A system comprising a modular electrical accessory (300) according to any of claims 1 to 13 and further comprising a user-replaceable electrical accessory module (330), the user-replaceable electrical accessory module (330) being removably connectable by a user to the electrical bus (434) and the control bus (436) of the modular electrical accessory (300).

## Patentansprüche

1. Modulares elektrisches Zubehör (300) für ein Gebäude, wobei das modulare elektrische Zubehör (300) umfasst:
ein Gehäuse (310), das zum Befestigen an einer Gebäudestruktur ausgebildet ist;
eine elektrische Rückwandplatine (320), die in dem Gehäuse (310) montiert ist, wobei die elektrische Rückwandplatine (320) ausgebildet ist, um elektrisch mit einer dem Gebäude zugeordneten elektrischen Schaltung verdrahtet zu sein;
einen elektrischen Bus (434) und einen Steuerbus (436), die von einem Benutzer abnehmbar mit einem vom Benutzer austauschbaren elektrischen Zubehörmodul (330) schaltbar sind;
wobei der elektrische Bus (434) ausgebildet ist, um elektrische Leistung zwischen einem geschalteten, vom Benutzer austauschbaren elektrischen Zubehörmodul (330) und der elektrischen Rückwandplatine (320) zu übertragen; und
der Steuerbus (436) ausgebildet ist, um Steuersignale zwischen einem geschalteten, vom Benutzer austauschbaren elektrischen Zubehörmodul (330) und der elektrischen Rückwandplatine (320) zu kommunizieren, die zum Steuern einer Abgabe elektrischer Leistung an eine elektrische Vorrichtung auf der Grundlage der Steuersignale ausgebildet ist.

2. Modulares elektrisches Zubehör (300) nach Anspruch 1, wobei das vom Benutzer austauschbare elektrische Zubehörmodul (330) vom Benutzer zwischen Folgendem austauschbar ist:
einem Modul, um den Betrieb einer elektrischen Vorrichtung zu steuern; und
einem Modul, das einen mit einer elektrischen Vorrichtung schaltbaren Anschluss aufweist, um der elektrischen Vorrichtung elektrische und/oder Datendienste bereitzustellen.

3. Modulares elektrisches Zubehör (300) nach einem der Ansprüche 1 und 2, wobei eine elektrische Vorrichtung mit dem elektrischen Bus (434) geschaltet ist und das vom Benutzer austauschbare elektrische Zubehörmodul (330) ausgebildet ist, um die Abgabe elektrischer Leistung an den elektrischen Bus (434) auf der Grundlage von Steuersignalen vom Steuerbus (436) zu steuern, um den Betrieb der elektrischen Vorrichtung zu steuern, wobei der elektrische Bus (434) ausgebildet ist, um über die elektrische Rückwandplatine (320) elektrische Leistung von der elektrischen Schaltung zu empfangen.

4. Modulares elektrisches Zubehör (300) nach Anspruch 3, wobei das vom Benutzer austauschbare elektrische Zubehörmodul (330) einen Stromanschluss umfasst, die mit einer elektrischen Vorrichtung schaltbar ist, wobei der Stromanschluss ausgebildet ist, um elektrische Leistung aus dem elektrischen Bus (434) der elektrischen Vorrichtung bereitzustellen, wobei der Anschluss wahlweise einen Stromanschluss für Niederspannung und/oder einen Stromanschluss für besonders niedrige Spannung umfasst.

5. Modulares elektrisches Zubehör (300) nach einem der Ansprüche 3 oder 4, wobei das modulare elektrische Zubehör (300) weiter einen Sendeempfänger umfasst, der durch elektrische Leistung versorgt wird, die vom elektrischen Bus empfangen wird, wobei der Sendeempfänger ausgebildet ist, um Daten mit einer externen Vorrichtung zu kommunizieren, und das vom Benutzer austauschbare elektrische Zubehörmodul weiter einen mit einer elektrischen Vorrichtung schaltbaren Anschluss umfasst, wobei der Anschluss ausgebildet ist, um die Daten mit der elektrischen Vorrichtung zu kommunizieren.

6. Modulares elektrisches Zubehör (300) nach einem vorstehenden Anspruch, wobei das modulare elektrische Zubehör (300) eine Schnittstelle aufweist, die ausgebildet ist, einen gewünschten Betriebszustand einer elektrischen Vorrichtung zu empfangen.

7. Modulares elektrisches Zubehör (300) nach Anspruch 6, wobei die Schnittstelle eine Benutzeroberfläche umfasst, die ausgebildet ist, um eine Eingabe von einem Benutzer zu empfangen, die den gewünschten Betriebszustand der elektrischen Vorrichtung angibt, beispielsweise eines oder mehrere von: einem Kippschalter, einem oder mehreren Drucktastern, einem Dimmerschalter, einem Touchpanel, einem Spracherkennungsprozessor, einem Bewegungssensor und einer variablen Steuereinheit.

8. Modulares elektrisches Zubehör (300) nach Anspruch 6, weiter umfassend eine kabelgebundene oder drahtlose Kommunikationsschnittstelle, die ausgebildet ist, um den gewünschten Betriebszustand zwischen der Kommunikationsschnittstelle und einer externen Vorrichtung zu kommunizieren, wobei die externe Vorrichtung eines oder mehreres ist von: einer externen elektronischen Vorrichtung; einer Brücke und einem weiteren modularen elektrischen Zubehör.

9. Modulares elektrisches Zubehör (300) nach einem der Ansprüche 6 bis 8, wobei die Schnittstelle ausgebildet ist, um die Abgabe elektrischer Leistung an eine mit dem elektrischen Bus (434) geschaltete elektrische Vorrichtung zu steuern, wobei der Steuerbus (436) ausgebildet ist, um Steuersignale von der Schnittstelle zum Steuern von Abgabe elektrischer Leistung durch den elektrischen Bus (434) an die elektrische Vorrichtung auf der Grundlage der Steuersignale zu kommunizieren,
wobei die Schnittstelle ausgebildet ist, um Steuersignale an den Steuerbus (436) auszugeben, die den gewünschten Betriebszustand der elektrischen Vorrichtung angeben.

10. Modulares elektrisches Zubehör (300) nach einem vorstehenden Anspruch, wobei die elektrische Rückwandplatine (320) weiter eine drahtgebundene oder drahtlose Kommunikationsschnittstelle umfasst, die ausgebildet ist, um Steuersignale zwischen dem Steuerbus (436) und einer externen Vorrichtung zu kommunizieren.

11. Modulares elektrisches Zubehör (300) nach einem vorstehenden Anspruch, weiter umfassend eine Steuerkomponente, die ausgebildet ist, um:
Steuersignale vom Steuerbus (436) zu empfangen; und
eine Abgabe elektrischer Leistung durch den elektrischen Bus (434) an die elektrische Vorrichtung auf der Grundlage der Steuersignale zu steuern.

12. Modulares elektrisches Zubehör (300) nach Anspruch 11, weiter umfassend:
eine Vielzahl von vom Benutzer austauschbaren elektrischen Zubehörmodulen (330), die ausgebildet sind, um elektrische Leistung vom elektrischen Bus (434) zu empfangen und Steuersignale auf dem Steuerbus (436) zu kommunizieren,
wobei die Steuersignale weiter eine eindeutige Kennung umfassen, die einem ausgewählten, vom Benutzer austauschbaren elektrischen Zubehörmodul (330) zugeordnet ist, und
eine Steuerkomponente, die ausgebildet ist, um als Reaktion auf die Steuersignale, welche die dem ausgewählten vom Benutzer austauschbaren elektrischen Zubehörmodul (330) zugeordnete eindeutige Kennung umfassen, Leistung an das ausgewählte vom Benutzer austauschbare elektrische Zubehörmodul abzugeben.

13. Modulares elektrisches Zubehör (300) nach einem vorstehenden Anspruch, wobei das Gehäuse eine elektrische Backbox zur Montage an einer Gebäudestruktur ist, die weiter eine Frontplatte umfasst, die ausgebildet ist, um das vom Benutzer austauschbare elektrische Zubehörmodul (330) an der elektrischen Backbox zu sichern.

14. System, umfassend ein modulares elektrisches Zubehör in Kommunikation mit einem weiteren modularen elektrischen Zubehör, wobei:
das modulare elektrische Zubehör umfasst:
ein vom Benutzer austauschbares elektrisches Zubehörmodul, das durch einen Steuerbus mit einer Kommunikationsschnittstelle im modularen elektrischen Zubehör abnehmbar schaltbar ist, um Steuersignale zwischen dem vom Benutzer austauschbaren elektrischen Zubehörmodul und der Kommunikationsschnittstelle zu kommunizieren, wobei das vom Benutzer austauschbare elektrische Zubehörmodul eine Benutzeroberfläche umfasst, die ausgebildet ist, um einen gewünschten Betriebszustand einer mit dem weiteren elektrischen Zubehörmodul geschalteten elektrischen Vorrichtung zu empfangen und den gewünschten Betriebszustand als Steuersignale auf dem Steuerbus zu kommunizieren;
wobei die Kommunikationsschnittstelle ausgebildet ist, um das Steuersignal vom Steuerbus zu empfangen und das Steuersignal, das den gewünschten Betriebszustand angibt, an das weitere modulare elektrische Zubehör zu senden; und
das weitere modulare elektrische Zubehör umfasst:
einen elektrischen Bus und einen weiteren Steuerbus, der abnehmbar mit einem weiteren vom Benutzer austauschbaren elektrischen Zubehörmodul schaltbar ist, wobei der elektrische Bus ausgebildet ist, um elektrische Leistung an das weitere vom Benutzer austauschbare elektrische Zubehörmodul zu übertragen, und der weitere Steuerbus ausgebildet ist, um Steuersignale an das weitere vom Benutzer austauschbare elektrische Zubehörmodul zu kommunizieren;
eine weitere Kommunikationsschnittstelle, die ausgebildet ist, um die Steuersignale vom modularen elektrischen Zubehör zu empfangen und die Steuersignale auf dem weiteren Steuerbus an das weitere vom Benutzer austauschbare elektrische Zubehörmodul zu kommunizieren;
wobei das weitere vom Benutzer austauschbare elektrische Zubehörmodul eine Steuerkomponente umfasst, die ausgebildet ist, um die Versorgung der mit dem elektrischen Bus geschalteten elektrischen Vorrichtung mit elektrischer Leistung auf der Grundlage des auf dem weiteren Steuerbus empfangenen Steuersignals zu steuern.

15. System, umfassend ein modulares elektrisches Zubehör (300) nach einem der Ansprüche 1 bis 13, und weiter umfassend ein vom Benutzer austauschbares elektrisches Zubehörmodul (330), wobei das vom Benutzer austauschbare elektrische Zubehörmodul (330) von einem Benutzer abnehmbar mit dem elektrischen Bus (434) und dem Steuerbus (436) des modularen elektrischen Zubehörs (300) schaltbar ist.

## Revendications

1. Accessoire électrique modulaire (300) destiné à un bâtiment, l'accessoire électrique modulaire (300) comprenant :
un boîtier (310) configuré pour être fixé à une structure de bâtiment ;
un fond de panier électrique (320) monté dans le boîtier (310), le fond de panier électrique (320) étant configuré pour être câblé électriquement à un circuit électrique associé au bâtiment ;
un bus électrique (434) et un bus de commande (436) pouvant être connectés de manière amovible, par un utilisateur, à un module (330) d'accessoire électrique remplaçable par l'utilisateur ;
dans lequel le bus électrique (434) est configuré pour transférer de l'énergie électrique entre un module (330) d'accessoire électrique remplaçable par l'utilisateur connecté et le fond de panier électrique (320) ; et
le bus de commande (436) est configuré pour communiquer des signaux de commande entre un module (330) d'accessoire électrique remplaçable par l'utilisateur connecté et le fond de panier électrique (320) est configuré pour commander la fourniture d'énergie électrique à un dispositif électrique sur la base des signaux de commande.

2. Accessoire électrique modulaire (300) selon la revendication 1, dans lequel le module (330) d'accessoire électrique remplaçable par l'utilisateur est interchangeable par l'utilisateur entre :
un module de commande du fonctionnement d'un dispositif électrique ; et
un module présentant une prise pouvant être connectée à un dispositif électrique pour fournir des services électriques et/ou de données au dispositif électrique.

3. Accessoire électrique modulaire (300) selon l'une de la revendication 1 et de la revendication 2, dans lequel un dispositif électrique est connecté au bus électrique (434) et le module (330) d'accessoire électrique remplaçable par l'utilisateur est configuré pour commander la fourniture d'énergie électrique au bus électrique (434) sur la base de signaux de commande provenant du bus de commande (436) afin de commander le fonctionnement du dispositif électrique,
dans lequel le bus électrique (434) est configuré pour recevoir de l'énergie électrique provenant du circuit électrique via le fond de panier électrique (320).

4. Accessoire électrique modulaire (300) selon la revendication 3, dans lequel le module (330) d'accessoire électrique remplaçable par l'utilisateur comprend une prise électrique pouvant être connectée à un dispositif électrique, dans lequel la prise électrique est configurée pour fournir de l'énergie électrique au dispositif électrique à partir du bus électrique (434), facultativement dans lequel la prise comprend une prise électrique basse tension et/ou une prise électrique très basse tension.

5. Accessoire électrique modulaire (300) selon l'une de la revendication 3 ou de la revendication 4, dans lequel l'accessoire électrique modulaire (300) comprend en outre un émetteur-récepteur alimenté par de l'énergie électrique reçue du bus électrique, dans lequel l'émetteur-récepteur est configuré pour communiquer des données avec un dispositif externe, et le module d'accessoire électrique remplaçable par l'utilisateur comprend en outre une prise pouvant être connectée à un dispositif électrique, dans lequel la prise est configurée pour communiquer les données avec le dispositif électrique.

6. Accessoire électrique modulaire (300) selon une quelconque revendication précédente, où l'accessoire électrique modulaire (300) présente une interface configurée pour recevoir un état de fonctionnement souhaité d'un dispositif électrique.

7. Accessoire électrique modulaire (300) selon la revendication 6, dans lequel l'interface comprend une interface utilisateur configurée pour recevoir une entrée d'un utilisateur indiquant l'état de fonctionnement souhaité du dispositif électrique, par exemple, un ou plusieurs parmi : un interrupteur à bascule ; un ou plusieurs interrupteurs à bouton-poussoir ; un interrupteur à gradation de lumière ; un écran tactile ; un processeur de reconnaissance vocale ; un capteur de mouvement ; et un dispositif de commande variable.

8. Accessoire électrique modulaire (300) selon la revendication 6, comprenant en outre une interface de communication filaire ou sans fil configurée pour communiquer l'état de fonctionnement souhaité entre l'interface de communication et un dispositif externe, dans lequel le dispositif externe est un ou plusieurs parmi : un dispositif électronique externe ; un pont ; et un accessoire électrique modulaire supplémentaire.

9. Accessoire électrique modulaire (300) selon l'une quelconque des revendications 6 à 8, dans lequel l'interface est configurée pour commander la fourniture d'énergie électrique à un dispositif électrique connecté au bus électrique (434), dans lequel le bus de commande (436) est configuré pour communiquer des signaux de commande provenant de l'interface pour commander la fourniture d'énergie électrique par le bus électrique (434) au dispositif électrique sur la base des signaux de commande,
dans lequel l'interface est configurée pour délivrer en sortie des signaux de commande sur le bus de commande (436) indiquant l'état de fonctionnement souhaité du dispositif électrique.

10. Accessoire électrique modulaire (300) selon une quelconque revendication précédente, dans lequel le fond de panier électrique (320) comprend en outre une interface de communication filaire ou sans fil configurée pour communiquer des signaux de commande entre le bus de commande (436) et un dispositif externe.

11. Accessoire électrique modulaire (300) selon une quelconque revendication précédente, comprenant en outre un composant de commande configuré pour :
recevoir des signaux de commande provenant du bus de commande (436) ; et
commander la fourniture d'énergie électrique par le bus électrique (434) au dispositif électrique sur la base des signaux de commande.

12. Accessoire électrique modulaire (300) selon la revendication 11, comprenant en outre :
une pluralité de modules (330) d'accessoires électriques remplaçables par l'utilisateur configurés pour recevoir de l'énergie électrique provenant du bus électrique (434) et communiquer des signaux de commande sur le bus de commande (436),
dans lequel les signaux de commande comprennent en outre un identifiant unique associé à un module (330) d'accessoire électrique remplaçable par l'utilisateur sélectionné, et
un composant de commande configuré pour fournir de l'énergie au module d'accessoire électrique remplaçable par l'utilisateur sélectionné en réponse aux signaux de commande comprenant l'identifiant unique associé au module (330) d'accessoire électrique remplaçable par l'utilisateur sélectionné.

13. Accessoire électrique modulaire (300) selon une quelconque revendication précédente, dans lequel le boîtier est un boîtier arrière électrique destiné à être monté sur une structure de bâtiment, comprenant en outre un plateau configuré pour fixer le module (330) d'accessoire électrique remplaçable par l'utilisateur au boîtier arrière électrique.

14. Système comprenant un accessoire électrique modulaire en communication avec un accessoire électrique modulaire supplémentaire, dans lequel :
l'accessoire électrique modulaire comprend :
un module d'accessoire électrique remplaçable par l'utilisateur pouvant être connecté de manière amovible à une interface de communication dans l'accessoire électrique modulaire par un bus de commande pour communiquer des signaux de commande entre le module d'accessoire électrique remplaçable par l'utilisateur et l'interface de connexion, dans lequel le module d'accessoire électrique remplaçable par l'utilisateur comprend une interface utilisateur configurée pour recevoir un état de fonctionnement souhaité d'un dispositif électrique connecté au module d'accessoire électrique supplémentaire et communiquer l'état de fonctionnement souhaité sous forme de signaux de commande sur le bus de commande ;
dans lequel l'interface de communication est configurée pour recevoir le signal de commande provenant du bus de commande et envoyer le signal de commande indiquant l'état de fonctionnement souhaité à l'accessoire électrique modulaire supplémentaire ; et
l'accessoire électrique modulaire supplémentaire comprend :
un bus électrique et un bus de commande supplémentaire pouvant être connecté de manière amovible à un module d'accessoire électrique remplaçable par l'utilisateur supplémentaire, dans lequel le bus électrique est configuré pour transférer de l'énergie électrique au module d'accessoire électrique remplaçable par l'utilisateur supplémentaire et le bus de commande supplémentaire est configuré pour communiquer des signaux de commande au module d'accessoire électrique remplaçable par l'utilisateur supplémentaire ;
une interface de communication supplémentaire configurée pour recevoir les signaux de commande provenant de l'accessoire électrique modulaire et communiquer les signaux de commande sur le bus de commande supplémentaire au module d'accessoire électrique supplémentaire remplaçable par l'utilisateur ;
dans lequel le module d'accessoire électrique remplaçable par l'utilisateur supplémentaire comprend un composant de commande configuré pour commander l'alimentation en énergie électrique du dispositif électrique connecté au bus électrique sur la base du signal de commande reçu sur le bus de commande supplémentaire.

15. Système comprenant un accessoire électrique modulaire (300) selon l'une quelconque des revendications 1 à 13 et comprenant en outre un module (330) d'accessoire électrique remplaçable par l'utilisateur, le module (330) d'accessoire électrique remplaçable par l'utilisateur pouvant être connecté de manière amovible par un utilisateur au bus électrique (434) et au bus de commande (436) de l'accessoire électrique modulaire (300).
